(19) Europäisches Patentamt
European Patent Office
Office européen des brevets

(11) Veröffentlichungsnummer: **0 218 977**
**A2**

## (12) EUROPÄISCHE PATENTANMELDUNG

(21) Anmeldenummer: **86113389.0**

(22) Anmeldetag: **29.09.86**

(51) Int. Cl.⁴: **H05K 1/03**

(30) Priorität: **16.10.85 DE 3536883**

(43) Veröffentlichungstag der Anmeldung:
**22.04.87 Patentblatt 87/17**

(84) Benannte Vertragsstaaten:
**AT BE CH DE FR GB IT LI NL SE**

(71) Anmelder: **ISOLA WERKE AG**
**Isolastrasse 2**
**D-5160 Düren(DE)**

(72) Erfinder: **Hartmann, Helmut**
**Wilhelm-Böhler-Strasse 30**
**D-5166 Kreuzau-Bilstein(DE)**
Erfinder: **Borchard, Kurt**
**Heribertstrasse 12**
**D-5166 Kreuzau(DE)**

(74) Vertreter: **Patentanwälte TER MEER - MÜLLER**
**- STEINMEISTER**
**Mauerkircherstrasse 45**
**D-8000 München 80(DE)**

(54) **Basismaterial für gedruckte Schaltungen.**

(57) Beschrieben wird ein Basismaterial für gedruckte Schaltungen aus verstärkenden Glasgewebelagen und einem ausgehärteten duroplastischen Harz, welches einen thermischen Ausdehnungskoeffizienten besitzt, der dem von aufgebrachten Keramikmaterialien gleicht, und welches ein duroplastisches Harz enthält, welches in ausgehärtetem Zustand eine Glasübergangstemperatur unterhalb 90°C besitzt.

EP 0 218 977 A2

## Basismaterial für gedruckte Schaltungen

Gegenstand der Erfindung ist ein Basismaterial für gedruckte Schaltungen aus verstärkenden Glasgeweben und einem ausgehärteten duroplastischen Harz, welches einen thermischen Ausdehnungskoeffizienten besitzt, der dem von Keramikmaterialien gleicht, die zur Fixierung von integrierte Schaltungen aufweisenden elektronischen Bauelementen eingesetzt werden.

Im Zuge der Entwicklung von elektronischen Bauelementen mit immer höher integrierten Schaltungen, der sogenannten Chips, wachsen die Schwierigkeiten, diese vielpoligen Bauelemente elektrisch mit den Leiterzügen der Leiterplatte zu verbinden. Eine neuere Entwicklung besteht darin, sogenannte Chip-Carriers zu verwenden, d. h. ein Keramik-Bauteil mit rings um den Rand angeordneten Anschlußfahnen, in die die elektronischen Bauelemente eingesteckt werden. Auf diese Weise wird die Anschlußfläche vergrößert und damit Platz für mehr Anschlußpunkte des elektronischen Bauelements geschaffen. Andererseits kann der Chip-Carrier direkt auf die Leiterplatte aufgelötet werden, die thermische Belastung des eigentlichen elektronischen Bauelements wird vermieden.

Das Problem beim Auflöten dieser keramischen Zwischenglieder auf die Leiterplatte ist in dem großen Unterschied der thermischen Ausdehnungskoeffizienten zwischen dem Basismaterial der gedruckten Schaltung und dem Keramikmaterial zu sehen. Dies hat zur Folge, daß beim Abkühlen der bei 250°C gelöteten Leiterplatte die keramischen Zwischenglieder abspringen oder zerreißen. Je größer diese keramischen Zwischenglieder oder Chip-Carrier werden, um so größer ist auch die Gefahr, daß sie aufgrund der unterschiedlichen thermischen Ausdehnungskoeffizienten sich von der Leiterplatte lösen, wenn diese starken Temperaturänderungen ausgesetzt wird.

Es wurde bereits in der EP-OS 0 064 854 vorgeschlagen, dieses Problem durch Anordnen einer elastischen Zwischenschicht zwischen den Leiterbahnen und dem sie tragenden Basismaterial zu lösen, welche die thermischen Zugspannungen in der x-und y-Richtung zwischen den Leiterzügen und dem Basismaterial aufzufangen in der Lage ist.

Nach einem anderen Vorschlag wird eine Invarplatte, deren Ausdehnungskoeffizient geringer als der des Keramikmaterials ist, in das Basismaterial eingepreßt. Die Kombination dieser Invarplatte mit den beidseitig aufgebrachten glasfaserverstärkten Epoxidharz-Abdeckungen ergibt ein Basismaterial, welches etwa den gleichen Ausdehnungskoeffizienten wie das Keramikmaterial besitzt. Diese Invarplatte ist sehr teuer. Der Hauptnachteil dieser Lösung ist aber darin zu sehen, daß der in das Basismaterial eingebrachte Metallkern eine große Vielzahl von Bohrungen zur Sicherstellung der Durchkontaktierung aufweisen muß, wenn Schaltungen mit zwei oder mehr Ebenen hergestellt werden sollen. Diese zahlreichen Bohrungen sind nicht nur aufwendig in der Herstellung, sondern beeinträchtigen auch die Wirkung des Metallkerns.

Es wurde weiterhin versucht, durch eine Steigerung der Glasübergangstemperatur der Matrix des Glasharzgewebes des Basismaterials die gesamte. thermische Materialbewegung zu verringern.

Es hat sich aber ergeben, daß diese Arbeitsrichtung zwar in der z-Ausdehnung sehr wirksam ist, aber in der x-oder y-Richtung nichts bringt, ganz abgesehen davon, daß die Polyimidharze um den Faktor 10 bis 15 kostspieliger als Epoxidharze sind und eine außerordentlich schwierige und diffizile Verarbeitungstechnik erfordern.

Es ist weiterhin versucht worden, das Glasgewebe des Basismaterials durch Quarzglasgewebe oder ein aromatisches Polyamidgewebe zu ersetzen. In beiden Fällen ergeben sich jedoch erhebliche Kostensteigerungen, wobei auch der erzielte Erfolg im Hinblick auf die Anpassung der thermischen Ausdehnungskoeffizienten nicht zu befriedigen vermag.

Die Aufgabe der vorliegenden Erfindung besteht somit darin, ein Basismaterial für gedruckte Schaltungen der eingangs angegebenen Gattung zu schaffen, welches einen thermischen Ausdehnungskoeffizienten besitzt, der weitgehend dem der Keramikmaterialien gleicht, die durch Auflöten an diesen Basismaterialien befestigt werden.

Überraschenderweise hat sich gezeigt, daß diese Aufgabe dadurch gelöst werden kann, daß man eine Harzmatrix mit möglichst niedriger Glasübergangstemperatur verwendet. So hat sich erwiesen, daß die Eigenausdehnung des Kunstharzes um so mehr zurücktritt und die thermische Bewegung des Glasgewebes um so dominierender wird, je niedriger die Glasübergangstemperatur der Harzmatrix liegt. Erfindungsgemäß wird somit ein duroplastisches Harz eingesetzt, welches eine wesentlich unterhalb des üblichen Bereichs liegende Glasübergangstemperatur aufweist und damit bei der Erwärmung mehr plastische statt elastische Eigenschaften aufweist. In diesem plastischen Zustand folgt das Harz voll der thermischen Bewegung des Glasgewebes. Da das üblicherweise eingesetzte Glasgewebe im Bereich von 20 bis 75°C einen thermischen Ausdehnungskoeffizienten von $4,8 \times 10^{-6}$/°C aufweist, der nur geringfügig unterhalb des thermischen Ausdehnungskoeffizienten der üblicherweise eingesetzten Keramikmaterialien von 6,5 x 10⁻⁵/°C liegt, wird es in dieser Weise möglich, die oben angesprochenen Probleme zu lösen und das Abplatzen der auf das Basismaterial aufgelöteten Keramikmaterialien beim Abkühlen zu verhindern.

Die obige Aufgabe wird daher gelöst durch die kennzeichnenden Merkmale des Basismaterials gemäß Hauptanspruch. Die Unteransprüche betreffen besonders bevorzugte Ausführungsformen dieses Erfindungsgegenstandes.

Die Erfindung betrifft somit ein Basismaterial für gedruckte Schaltungen aus verstärkenden Glasgewebelagen und einem ausgehärteten duroplastischen Harz, welches dadurch gekennzeichnet ist, daß das duroplastische Harz im ausgehärteten Zustand eine Glasübergangstemperatur unterhalb 90°C aufweist.

Da üblicherweise für solche Basismaterialien duroplastische Harze mit einer Glasübergangstemperatur von 130°C eingesetzt werden und zur Lösung der oben angesprochenen Probleme eher versucht worden ist, die Glasübergangstemperatur anzuheben, um sie in den Bereich der Lötbadtemperatur zu bringen, muß das erfindungsgemäß erzielte Ergebnis überraschen.

Gemäß einer bevorzugten Ausführungsform der Erfindung besitzt das duroplastische Harz des erfindungsgemäßen Basismaterials im ausgehärteten Zustand eine Glasübergangstemperatur im Bereich von 30 bis 70°C und insbesondere von etwa 30°C. Diese Glasübergangstemperatur kann in üblicher Weise eingestellt werden, beispielsweise durch den physikalischen Zusatz und/oder den chemischen Einbau von elastifizierenden Bestandteilen, Weichmachern oder dergleichen. Die Glasübergangstemperatur kann durch Schwingungsmessungen unter Erwärmen oder durch thermomechanische Analyse bestimmt werden.

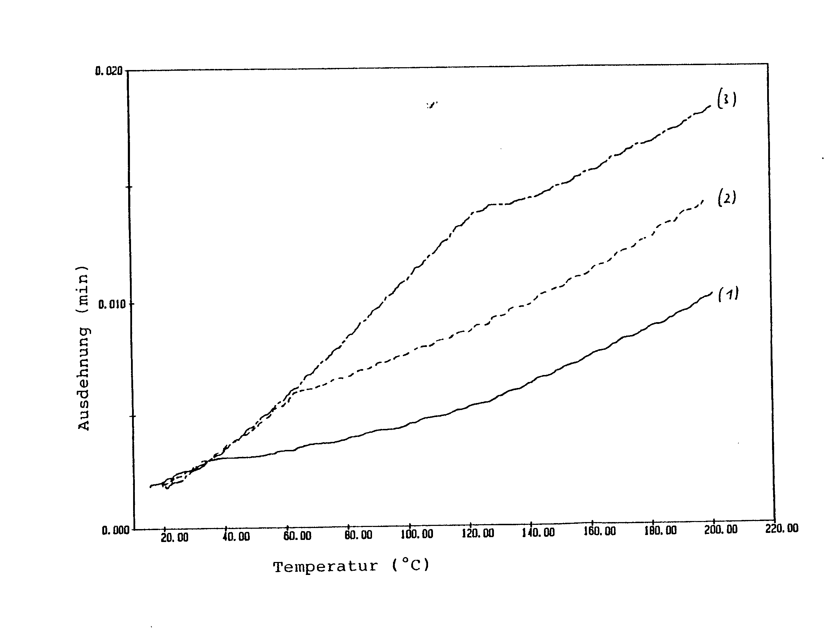

Die beigefügte Zeichnung zeigt in der einzigen Figur die Ergebnisse der thermomechanischen Analyse der Produkte der Beispiele 1 und 2 sowie des Vergleichsbeispiels 2.

Dabei steht die Kurve 1 für das Material des Beispiels 1, die Kurve 2 des Materials des Beispiels 2 und die Kurve 3 für das Material des Vergleichsbeispiels 2. Die jeweiligen Glasumwandlungstemperaturen sind ohne weiteres an den Abknickpunkten der dargestellten Kurven ablesbar und betragen etwa 30°C (Beispiel 1), 60°C (Beispiel 2) bzw. 120° C (Vergleichsbeispiel 2). Diese thermomechanische Analyse wurde an einer Probe von ca. 7,3 mm Größe, mit einer Aufheizgeschwindigkeit von 10°C/min und einem Auflagegewicht von 3,5 g durchgeführt.

Erfindungsgemäß kann als duroplastisches Harz ein Epoxidharz oder ein Phenolharz eingesetzt werden, wobei diese Materialien in elastifiziertem Zustand eingesetzt werden, damit sie die oben angesprochene Glasübergangstemperatur von unterhalb 70°C aufweisen.

Weiterhin hat es sich als besonders vorteilhaft erwiesen, die verstärkenden Glasgewebelagen in kreuzverlegtem Zustand anzuordnen, d. h. in der Weise, daß bei aufeinanderfolgenden Glasgewebelagen die Kettrichtung bzw. die Schußrichtung des Glasgewebes um jeweils 90° gedreht sind, d.h. einmal in der Maschinenrichtung und einmal quer dazu. In dieser Weise wird eine Egalisierung der thermischen Ausdehnung in der x-und y-Richtung erreicht, da durch die abweichende Fadenzahl in Kett-und Schußrichtung sowie durch die starke Spannung des Gewebes in der Kettrichtung beim Imprägnieren mit dem Kunstharz Unterschiede in die sen beiden Richtungen auftreten, die durch dieses Kreuzverlegen der einzelnen Glasgewebebögen kompensiert werden. Statt des Glasgewebes können als verstärkende Gewebelagen auch Gewebe aus anderen Materialien eingesetzt werden, wesentlich ist es jedoch, ein verstärkendes Gewebe einzusetzen, dessen thermischer Ausdehnungskoeffizient möglichst gut mit demjenigen des auf das Basismaterial aufzubringenden Keramikmaterials übereinstimmt.

Die folgenden Beispiele dienen der weiteren Erläuterung der Erfindung.

Beispiel 1

Man imprägniert ein Glasgewebe (Typ Nr. 7628, dem Standardgewebe der Basismaterialherstellung) mit einem Flächengewicht von 200 g/m², einer Dicke von 180 μm und einer Fadenstellung von 17 x 13 pro cm mit einer Lösung eines stark weichgemachten Epoxidharzes. Das reine ausgehärtete Harz besitzt eine differentialthermoanalytisch gemessene Glasübergangstemperatur von etwa 30°C. Der Gesamtharzgehalt der imprägnierten Prepregs beträgt 42 %, die Gelierzeit bei 170°C 15 bis 20 s und der Harzfluß 6 bis 8 % (alle Messungen werden nach der Vorschrift IEC 249-3-1 durchgeführt).

Aus abwechselnd kreuzverlegten Bögen dieses imprägnierten Gewebes, die beidseitig mit einer 35 μm dicken Kupferfolie abgedeckt werden, wird durch Verpressen während 90 Minuten bei 175°C und einem Druck von 60 bar ein Basismaterial mit einer Dicke von 1,6 mm gebildet. Die Glasübergangstemperatur des fertigen Basismaterials beträgt etwa 30 °C. Der thermische Ausdehnungskoeffizient ist in der x-und der y-Richtung gleich und beträgt etwa 6 x 10⁻⁵/°C.

Vergleichsbeispiel 1

Man imprägniert das in Beispiel 1 beschriebene Glasgewebe mit einem Standardepoxidharz mit einer Glasübergangstemperatur von 130°C. Man arbeitet bei einem Harzgehalt in dem imprägnierten Gewebe von 42 %, einer Gelzeit von ca. 115 s und einer Auspressung von etwa 18 %.

Die in dieser Weise imprägnierten Glasgewebe werden "gleichlaufend" geschichtet und unter Anwendung der in Beispiel 1 beschriebenen Bedingungen verpreßt. Man erhält ein Basismaterial mit einem thermischen Ausdehnungskoeffizienten in der x-Richtung von $16,7 \times 10^{-6}/°C$ und in der y-Richtung von $11,8 \times 10^{-6}/°C$.

Vergleichsbeispiel 2

Man arbeitet nach der Verfahrensweise des Vergleichsbeispiels 1, schichtet jedoch das imprägnierte Glasgewebe kreuzweise, wie in Beispiel 1 beschrieben, und fertigt das Basismaterial im übrigen unter Anwendung der oben angegebenen Bedingungen. Man erhält ein Basismaterial mit einem thermischen Ausdehnungskoeffizienten von $14 \times 10^{-6}/°C$ in beiden Richtungen.

Beispiel 2

Man verfährt wie in Beispiel 1, verwendet jedoch eine Harzmischung aus einem stark plastifizierten und einem nichtplastifizierten Epoxidharz, so daß eine Glasübergangstemperatur der Mischung von etwa 70°C gegeben ist.

Man erhält ein Basismaterial mit einem thermischen Ausdehnungskoeffizienten von $9 \times 10^{-6}/°C$.

**Ansprüche**

1. Basismaterial für gedruckte Schaltungen aus verstärkenden Glasgewebelagen und einem ausgehärteten duroplastischen Harz, **dadurch gekennzeichnet,** daß das duroplastische Harz im ausgehärteten Zustand eine Glasübergangstemperatur unterhalb 90°C aufweist.

2. Basismaterial nach Anspruch 1, **dadurch gekennzeichnet,** daß das duroplastische Harz im ausgehärteten Zustand eine Glasübergangstemperatur im Bereich von 30 bis 70°C aufweist.

3. Basismaterial nach den Ansprüchen 1 oder 2, **dadurch gekennzeichnet,** daß es als duroplastisches Harz ein elastifiziertes Epoxidharz enthält.

4. Basismaterial nach den Ansprüchen 1 bis 3, **dadurch gekennzeichnet,** daß es als duroplastisches Harz ein elastifiziertes Phenolharz enthält.

5. Basismaterial nach den Ansprüchen 1 bis 4, **dadurch gekennzeichnet,** daß die verstärkenden Glasgewebelagen kreuzverlegt sind.

0 218 977